# EUROPÄISCHE PATENTSCHRIFT

(11) **EP 2 656 412 B1**
(45) Veröffentlichungstag und Bekanntmachung des Hinweises auf die Patenterteilung: **18.11.2020**
(21) Anmeldenummer: 12700039.6
(22) Anmeldetag: 05.01.2012
(51) Int. Cl.: H01L 51/00, H01L 51/50

(54) **ORGANISCHES HALBLEITERBAUELEMENT MIT DOTIERTER LOCHLEITERSCHICHT**
ORGANIC SEMICONDUCTOR COMPONENT COMPRISING A DOPED HOLE CONDUCTOR LAYER
COMPOSANT SEMI-CONDUCTEUR ORGANIQUE PRÉSENTANT UNE COUCHE CONDUCTRICE À TROUS DOPÉE

(30) Priorität: 26.01.2011 DE 102011003192
(43) Veröffentlichungstag der Anmeldung: 30.10.2013
(73) Patentinhaber: Novaled GmbH, 01099 Dresden (DE)
(72) Erfinder: SCHMID, Günter, 91334 Hemhofen (DE); WEMKEN, Jan Hauke, 90449 Nürnberg (DE); KELLERMANN, Renate, 91058 Erlangen (DE); MALTENBERGER, Anna, 91359 Leutenbach (DE)
(74) Vertreter: Michalski Hüttermann & Partner Patentanwälte mbB
(86) Internationale Anmeldenummer: PCT/EP2012/050117
(87) Internationale Veröffentlichungsnummer: WO 2012/100972

(56) Entgegenhaltungen:
- EP-A2- 0 948 063
- WO-A2-2006/086480
- US-A- 5 853 906
- US-A1- 2007 069 185
- US-A1- 2009 211 640
- US-A1- 2010 109 000
- NEIL G. CONNELLY ET AL: "Chemical Redox Agents for Organometallic Chemistry", CHEMICAL REVIEWS, ACS, AMERICAN CHEMICAL SOCIETY, Bd. 96, Nr. 2, 1. Januar 1996 (1996-01-01) , Seiten 877-910, XP55018130, ISSN: 0009-2665, DOI: 10.1021/cr940053x
- AGNES KÜTT ET AL: "Equilibrium Acidities of Superacids", JOURNAL OF ORGANIC CHEMISTRY, vol. 76, no. 2, 17 December 2010 (2010-12-17), pages 391-395, XP055235130, US ISSN: 0022-3263, DOI: 10.1021/jo101409p

## Beschreibung

Die vorliegende Erfindung betrifft organische Halbleiterbauelemente und deren Herstellung.

Im Bereich der organischen Halbleiter ist bekannt, dass zum Transport von Elektronen als Ladungsträger Elektronentransportschichten und zum Transport von Löchern als Ladungsträger Lochtransportschichten eingesetzt werden müssen.

Eine organische Leuchtdiode ist nur ein Beispiel aus dem Stand der Technik in dem zur Erhöhung der Leitfähigkeit von Ladungstransportschichten und sogenannten "Charge-Generation-Layers" eine Dotierung eingesetzt wird. Auch in organischen Feldeffekttransistoren, Solarzellen oder Fotodetektoren stellt sich das Problem der Dotierung, beispielsweise für Injektionsschichten zur Verringerung des Kontaktwiderstandes, beispielsweise an Source- und Drain-Elektroden oder Elektroden allgemein.

Grundsätzlich ist für die Dotierung organischer Materialien bekannt, z.B. Dotiermoleküle oder Dotierionen in eine Matrix aus einer organischen Substanz einzubringen. Für die p-Dotierung von Lochleiterschichten werden Elektronenakzeptoren eingebracht. Als derartige zur p-Dotierung geeigneten Elektronenakzeptoren sind beispielsweise Metallkomplexe bekannt. Die bereits bekannten eingesetzten Dotierstoffe haben zumeist Nachteile entweder in der Verarbeitung oder auch in ihrer Auswirkung auf Eigenschaften des Halbleiterbauteils außerhalb des Bereichs der Leitfähigkeitserhöhung. Derartige Bereiche sind z.B. die Effizienz und Lebensdauer. In den meisten organischen Halbleiterbauteilen hängen Effizienz und Lebensdauer stark von der Ladungsträgerdichte an verschiedenen Grenzflächen ab. Insbesondere in organischen Leuchtdioden bestimmt die Exitonendichte in der lichtemittierenden Schicht die Lichtausbeute und Effizienz des Bauteils.

Was die Verarbeitung der Dotierstoffe zur Herstellung des Bauelements angeht, existiert im Stand der Technik häufig das Problem, dass die Dotierstoffe auf eine Depositionsmethode beschränkt sind und dementsprechend ausschließlich aus der Gasphase oder ausschließlich aus der Flüssigphase verarbeitet werden können. Demnach sind diese Dotierstoffklassen auch auf jeweils eine Materialklasse für die Halbleitermatrix beschränkt. D.h. ein Dotierstoff, der nur aus der Flüssigphase abgeschieden werden kann, kann nur in eine Polymermatrix eingebracht werden. Ein Dotierstoff, der ausschließlich aus der Gasphase abgeschieden werden kann, kann nur in eine "Small-Molecule-Matrix" eingebracht werden. Bei der Eignung für die Abscheidung aus der Gasphase kommt noch hinzu, dass der Dotierstoff auf eine gewisse Temperatur erhitzt werden können muss, ohne dass sich dieser zersetzt. Nur wenn der Dotierstoff geeignet ist in einer Kondensationsreaktion zusammen mit dem Matrixmaterial eine dotierte Lochleiterschicht auszubilden, ist er für den Einsatz in der Bauteilherstellung zu berücksichtigen.

Neben diesen zusätzlichen Anforderungen an Dotierstoffe wird primär angestrebt, deren Dotierwirkung weiter zu verbessern und dadurch die Leitfähigkeit von organischen Halbleiterschichten weiter zu erhöhen.

Die US2010/0109000 A1 offenbart Zusammensetzungen zum Gebrauch in Lochleiterschichten oder Lochinjektionsschichten, Verfahren zur Herstellung dieser Zusammensetzungen, und Vorrichtungen die mit diesen Zusammensetzungen hergestellt werden können. Es können organische Leuchtdioden hergestellt werden. Die Zusammensetzungen bestehen aus zumindest einem leitfähigen konjugierten Polymer, zumindest einer halbleitenden Matrixkomponente, die unterschiedlich von dem leitfähigen konjugierten Polymer ist, und optional einem Dopant, wobei die Zusammensetzungen im Wesentlichen frei von einer isolierenden Matrixkomponente sind.

Es ist Aufgabe der vorliegenden Erfindung, ein Bauelement anzugeben, welches eine Lochleitschicht mit verbesserter Dotierung aufweist. Darüber hinaus ist es Aufgabe der vorliegenden Erfindung, ein Herstellungsverfahren für ein derartiges Bauelement anzugeben.

Die Aufgabe ist durch eine Vorrichtung gemäß dem Patentanspruch 1 gelöst. Zugehörige Herstellungsverfahren werden in Patentanspruch 4 und Patentanspruch 10 angegeben.

Vorteilhafte Ausgestaltungen der Erfindung sind Gegenstand der Unteransprüche. Die erfindungsgemäße Vorrichtung ist ein Halbleiterbauelement mit wenigstens einer organischen Lochleiterschicht. Diese Lochleiterschicht weist eine p-Dotierung mit einem Supersäurensalz auf. Das Supersäurensalz weist Silber(I)trifluormethansulfonat (Ag(I)TFMS) und/oder Kupfer(II)trifluormethansulfonat (Cu(II)TFMS) auf.

Die Substanzklasse der Supersäurensalze erweist sich überraschenderweise als sehr guter p-Dopant in Lochleiterschichten. Vorteil der Erfindung ist eine stark erhöhte Leitfähigkeit der Lochleiterschicht durch Einbringung der Dotierung bei sehr geringen Konzentrationen des Dotierstoffes.

In einer vorteilhaften Ausgestaltung der Erfindung weist das Halbleiterbauelement eine Lochleiterschicht auf, die eine spezifische Leitfähigkeit von mindestens 2,5 x 10⁻⁵ S/m aufweist, und dabei die Dotierkonzentration bei höchstens 20 Vol.-% liegt. Im Gegensatz zu bisher bekannten Dotierstoffklassen haben die Supersäurensalze den Vorteil bei geringen Konzentrationen in der Lochleitmatrix hohe Leitfähigkeiten zu erwirken.

In einer weiteren vorteilhaften Ausgestaltung der Erfindung zeigt das Halbleiterbauelement eine Lochleiterschicht auf, die eine p-Dotierung mit einem Supersäurensalz aufweist, wobei das Supersäurensalz Silber(I)trifluormethansulfonat (Ag(I)TFMS) aufweist und das Absorptionsvermögen der Lochleiterschicht im Wellenlängenbereich zwischen 400 nm und 700 nm durch die p-Dotierung mit dem Supersäurensalz im Wesentlichen nicht erhöht wird. Im Wesentlichen nicht erhöht bedeutet, dass der Farbeindruck für das menschliche Auge unverändert bleibt, ob eine Dotierung in die Matrix eingebracht ist oder nicht. Dies hat den Vorteil, dass die Dotierung den Farbeindruck insbesondere im ausgeschalteten Zustand des Bauelements nicht verändert. Der Farbeindruck ist insbesondere bei organischen Leuchtdioden von Bedeutung. Daher ist die erfindungsgemäße Dotierung für den Einsatz in organischen Leuchtdioden besonders bevorzugt.

Das Silber(I)trifluormethansulfonat hat dabei den Vorteil, die Leitfähigkeit auf bis zu über 7 x 10⁻⁵ S/m zu erhöhen, bei einer Dotierkonzentration von 10 % oder weniger. Dies entspricht einer Erhöhung der Stromdichte bei 1V Bauteilspannung und 200 nm Schichtdicke um 6 Größenordnungen. Der besondere Vorteil von Silber(I)trifluormethansulfonat liegt in der geringen Absorption im sichtbaren Wellenlängenbereich, welche bewirkt, dass die so dotierte Lochleiterschicht für das menschliche Auge farblich neutral erscheint. Das Kupfer(II) trifluormethansulfonat zeichnet sich als p-Dopant besonders dadurch aus, dass es die Leitfähigkeit der Lochleiterschicht auf bis zu über 5 x 10⁻² S/m bei einer Konzentration von 10 % erhöhen kann.

In einem erfindungsgemäßen Herstellungsverfahren für ein Halbleiterbauelement wird in einem Schritt eine organische Lochleiterschicht, die eine p-Dotierung mit einem Supersäurensalz aufweist, abgeschieden, wobei das Supersäurensalz ein Salz einer Supersäure aufweist, und wobei die Supersäure eine Säure mit einem Säurekonstantewert pKs kleiner als der von Schwefelsäure ist. Hierbei wird für die Abscheidung der Lochleiterschicht ein Matrixmaterial zusammen mit dem Supersäurensalz in einem gemeinsamen Schritt aus der Gasphase abgeschieden, wobei die Dotierkonzentration der Lochleiterschicht über die Verdampfungsraten des Supersäurensalzes und des Matrixmaterials in einer Ko-Verdampfung eingestellt wird.

Die über die Verdampfungsraten eingestellte Volumenkonzentration des p-Dopanten im Matrixmaterial kann von der tatsächlichen Volumenkonzentration in der fertig abgeschiedenen Lochleiterschicht abweichen.

Die erfindungsgemäße p-Dotierung mit Supersäurensalzen hat also den Vorteil, über die Wahl von Kation und Säureanion, den Dotierstoff sehr gut an das Matrixmaterial anpassen zu können.

Besonders die optischen Eigenschaften für den Einsatz des p-Dotierstoffes in organischen Leuchtdioden können durch diese neue Materialklasse für p-Dotierung stark verbessert werden. Eine hohe Leitfähigkeit wird schon bei geringen Dotierkonzentrationen erreicht. Im Bereich der organischen Displays oder Beleuchtungseinrichtungen kann über die erfindungsgemäße p-Dotierung ein Kompromiss zwischen optischen und elektrischen Eigenschaften erwirkt werden. Denn neben dem Dotiereffekt sind auch das optische Erscheinungsbild der dotierten Schichten von Bedeutung für die Qualität eines organischen Halbleiterbauteils, besonders für Displayanwendungen oder Beleuchtungszwecke.

Nicht einschränkende Beispiele für Supersäuren im Rahmen des oben definierten Begriffs sind:

### Anorganisch:

- Fluorsulfonsäure (HSO₃F)
- Fluor-Antimonsäure (HSbF₆)
- Tetrafluoroborsäure (HBF₄)
- Hexafluorophosphorsäure (HPF₆)
- Trifluoromethylsulfonsäure (HSO₃CF₃)

### Organisch:

- Pentacyanocyclopentadien (HC₅(CN)₅)
- Teilweise oder ganz fluorierte Derivate des Pentaphenylcyclopentadiens
- Penta-trifluoromethyl-pentadiens bzw. analoger Derviate
- Teilweise oder ganz fluorierte Derivate der Tetraphenylborsäure bzw. deren Cyanoderivate
- Teilweise oder ganz fluorierte Derivate der Arylsulfonsäuren bzw. deren Cyanoderivate
- Teilweise oder ganz fluorierte Derivate der Arylphosphonsäuren bzw. deren Cyanoderivate
- Anionen der Carborane wie beispielsweise [C₂B₁₀H₁₀]²⁻ oder [C₁B₁₁H₁₀]⁻

Die Trifluoromethylsulfonsäure (HSO₃CF₃) ist davon ein besonders geeigneter Vertreter.

Die Metallsalze von Supersäuren können mit vielen Kationen erhalten werden, welche beispielsweise aber nicht einschränkend sind:
- Kationen der Alkalimetalle
- Kationen der Erdalkalimetalle
- Kationen der Lanthanoiden (Seltene Erden: La, Ce, Pr, Nd, Sm, Eu, Gd, Tb, Dy, Ho, Er, Tm, Yb, Lu, Y)
- Kationen der Übergangsmetalle
- Aluminium-Kationen
- Kationische Metallkomplexe

Neben den klassischen Salzen der Alkali- und Erdalkalimetalle sind die Salze der seltenen Erden sowie von Scandium und Aluminium von Bedeutung in der organischen Synthese. Als besonders geeignet haben sich experimentell die Triflate, das heißt die Salze, insbesondere Metallsalze der Supersäure Trifluormethansulfonsäure (TFMS) erwiesen. Diese sehen in allgemeiner Form aus:

(MLₙ)^{x+}·[O₃S-CF₃⁻]ₓ

Dabei steht M für ein Metall, Lₙ für einen (n=1) oder mehrere (n=2,3,4,...) Liganden und x für die Ladung des Metallkomplexes. Als Kationen sind also insbesondere alle Kationen komplexer Natur oder Kationen ohne zusätzliche Liganden geeignet.

Die aufgeführten Kationen sind aber auch geeignet mit Anionen anderer Supersäuren Salze zu bilden, die als p-Dotierstoff eingesetzt werden können. Ganz besonders zu bevorzugen sind dabei die Triflate der Übergangsmetalle, insbesondere von Silber und von Kupfer.

Davon besonders geeignet haben sich:
- Kupfer(II)trifluormethansulfonat (Cu(II)TFMS, CAS-Nr. 34946-82-2, Verdampfungstemperatur: 350°C - 370°C @ 10⁻⁵ mbar - 10⁻⁶ mbar) 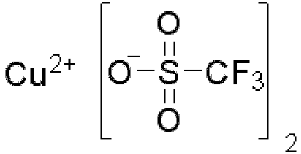
- Silber(I)trifluormethansulfonat (Ag(I)TFMS, CAS-Nr. 2923-28-6, Verdampfungstemperatur: 370°C - 380°C @ 10⁻⁵ mbar - 10⁻⁶ mbar)

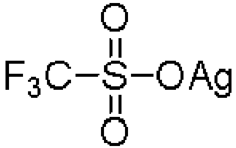

Überraschenderweise sind viele der so gebildeten Supersäurensalze flüchtig und können insbesondere im Rahmen einer Kokondensationsreaktion zusammen mit einem Lochleiter eine dotierte Lochleiterschicht ausbilden. Die Supersäurensalze sind besonders in wasserfreier Form auch sehr stabil und können sogar weit über 400°C erhitzt werden.

Kupfer(I)trifluormethansulfonat ist ausschließlich für Lösungsprozessierung geeignet, da es sich nicht unzersetzt verdampfen lässt. Dazu kann Kupfer(I)trifluormethansulfonat beispielsweise im Solvat mit Benzol (C₆H₆), Toluol (C₇H₈) oder Acetonitril (C₂H₃N) verarbeitet werden:

| Benzol | Toluol | Acetonitril |
|---|---|---|
| 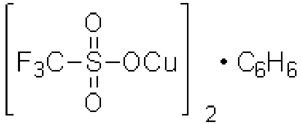 | 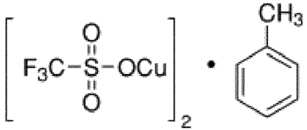 | 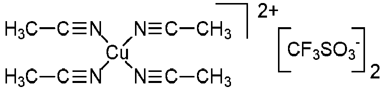 |

Ein wesentlicher Vorteil der Erfindung liegt in der Kostenersparnis. Die Verwendung von Salzen von Supersäuren als p-Doierstoffe für Lochleiterschichten in OLEDs birgt neben dem hohen Dotiervermögen gleichzeitig den Vorteil äußerst geringer Kosten. Die Kosten des derzeit eingesetzter p-Dotierstoffe liegen bei 2000 bis 7000€ /g je nach Abnahmemenge. Ag(I)CF₃SO₃ und Cu(II) [CF₃SO₃]₂ hingegen liegen bei weniger als 10€/g im normalen Feinchemikalienhandel. Darüber hinaus sind viele Vertreter dieser Klasse kommerziell erhältlich oder zumindest sind deren Herstellverfahren bekannt, gut ausgearbeitet und kostengünstig.

Organische Lochleiter sind im Allgemeinen aber nicht ausschließlich Abkömmlinge von Triarylaminen.

Als Lochtransporter, die aus der Gasphase abgeschieden werden können, kommen hierbei insbesondere aber nicht einschränkend in Frage:
- N,N'-Bis(naphthalen-1-yl)-N,N'-bis(phenyl)-9,9-dimethylfluorene
- N,N'-Bis(3-methylphenyl)-N,N'-bis(phenyl)-9,9-diphenylfluorene
- N,N'-Bis(naphthalen-1-yl)-N,N'-bis(phenyl)-9,9-diphenylfluorene
- N,N'-Bis(naphthalen-1-yl)-N,N'-bis(phenyl)-2,2-dimethylbenzidine
- N,N'-Bis(3-methylphenyl)-N,N'-bis(phenyl)-9,9-spirobifluorene
- 2,2',7,7'-Tetrakis(N,N-diphenylamino)-9,9'-spirobifluorene
- N,N'-Bis(naphthalen-1-yl)-N,N'-bis(phenyl)-benzidine
- N,N'-Bis(naphthalen-2-yl)-N,N'-bis(phenyl)-benzidine
- N,N'-Bis(3-methylphenyl)-N,N'-bis(phenyl)-benzidine
- N,N'-Bis(3-methylphenyl)-N,N'-bis(phenyl)-9,9-dimethyl-fluorene
- N,N'-Bis(naphthalen-1-yl)-N,N'-bis(phenyl)-9,9-spirobifluorene
- Di-[4-(N,N-ditolyl-amino)-phenyl]cyclohexane
- 2,2',7,7'-tetra(N, N-di-tolyl)amino-spiro-bifluorene
- 9,9-Bis[4-(N,N-bis-biphenyl-4-yl-amino)phenyl]-9H-fluorene
- 2,2',7,7'-Tetrakis[N-naphthalenyl(phenyl)-amino]-9,9-spirobifluorene
- 2,7-Bis[N,N-bis(9,9-spiro-bifluorene-2-yl)-amino]-9,9-spirobifluorene
- 2,2'-Bis[N,N-bis(biphenyl-4-yl)amino]-9,9-spirobifluorene
- N,N'-bis(phenanthren-9-yl)-N,N'-bis(phenyl)-benzidine
- N,N,N',N'-tetra-naphthalen-2-yl-benzidine
- 2,2'-Bis(N,N-di-phenyl-amino)-9,9-spirobifluorene
- 9,9-Bis[4-(N,N-bis-naphthalen-2-yl-amino)phenyl]-9H-fluorene
- 9,9-Bis[4-(N, N'-bis-naphthalen-2-yl-N,N'-bis-phenyl-amino)-phenyl]-9H-fluorene
- Titanium oxide phthalocyanine
- Copper phthalocyanine
- 2,3,5,6-Tetrafluoro-7,7,8,8,-tetracyano-quinodimethane
- 4,4',4"-Tris(N-3-methylphenyl-N-phenyl-amino)triphenylamine
- 4,4',4"-Tris(N-(2-naphthyl)-N-phenyl-amino)triphenylamine
- 4,4',4"-Tris(N-(1-naphthyl)-N-phenyl-amino)triphenylamine
- 4,4',4"-Tris(N,N-diphenyl-amino)triphenylamine
- Pyrazino[2,3-f][1,10]phenanthroline-2,3-dicarbonitrile
- N, N,N',N'-Tetrakis(4-methoxyphenyl)benzidine
- 2,7-Bis[N,N-bis(4-methoxy-phenyl)amino]-9,9-spirobifluorene
- 2,2'-Bis[N,N-bis(4-methoxy-phenyl)amino]-9,9-spirobifluorene
- N,N'-di(naphthalen-2-yl)-N,N'-diphenylbenzene-1,4-diamine
- N,N'-di-phenyl-N,N'-di-[4-(N,N-di-tolyl-amino)phenyl]benzidine
- N,N'-di-phenyl-N,N'-di-[4-(N, N-di-phenyl-amino)phenyl]benzidine
- NPB (N,N'-Di-[(1-naphthyl)-N,N'-diphenyl]-1,1'-biphenyl)-4,4'-diamine)

Diese monomolekularen Lochtransportmaterialien können auch aus der Flüssigphase abgeschieden werden oder zu den unten genannten polymeren Materialien in Lösung hinzugemischt werden. Wenn niedermolekulare und polymere Materialien gemischt werden, können über das Mischungsverhältnis (zwischen 0 und 100 %) die Filmbildungseigenschaften beeinflusst und verbessert werden.

Polymere Lochtransporter, die vornehmlich aus der Flüssigphase abgeschieden werden, sind insbesondere aber nicht einschränkend:

| | |
|---|---|
| - PEDOT (Poly(3,4 ethylenedioxythiophene)) | 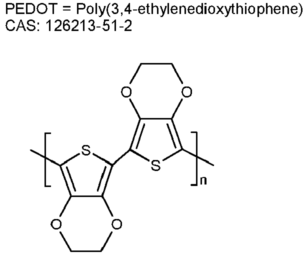 |
| - PVK (poly(9-vinylcarbazole)) | 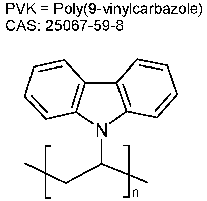 |
| - PTPD (poly(N,N'-bis(4-butylphenyl)-N,N'-bis(phenyl)-benzidine)) | 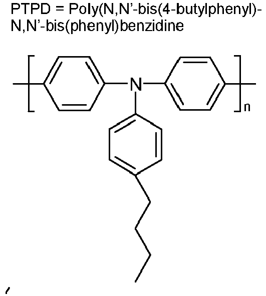 |
| - P3HT (poly(3-hexylthiophene)) | 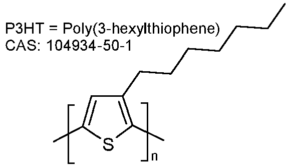 |
| - PANI (polyaniline) | 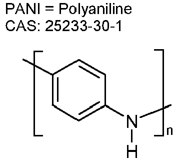 |

Im Sinne der Erfindung sind auch Mischungen aus den genannten polymeren Lochtransportmaterialien.
Als Lösungsmittel kommen bevorzugt organische Lösungsmittel zum Einsatz, wie zum Beispiel:
- Benzol,
- Chlorbenzol,
- Chloroform,
- Toluol,
- THF,
- Methoxypropylacetat,
- Anisol,
- Acetonitril,
- Phenetol oder
- Dioxan.

Ein weiterer besonderer Vorteil der Erfindung besteht darin, dass die für die p-Dotierung geeignete Materialklasse der Supersäurensalze mit der Lochleiter-Matrix aus der gleichen Gasphase abgeschieden wird.

Dies stellt eine signifikante Vereinfachung der Abscheideverfahren für die Bauteilherstellung dar.

Neben der besonderen Eignung der Substanzklasse der Supersäurensalze nach Definition der Erfindung für die Abscheidung dotierter Lochleiterschichten aus der Gasphase haben diese den weiteren besonderen Vorteil, dass über die Dotierung das Erscheinungsbild einer OLED im ausgeschalteten Zustand je nach Metallkation und Konzentration einstellbar ist.

Ausführungsformen der vorliegenden Erfindung werden in exemplarischer Weise mit Bezug auf die Figuren 1 bis 12 der angehängten Zeichnung beschrieben:
- Fig. 1: Schematischer Aufbau einer organischen Leuchtdiode
- Fig. 2: Koordination von NPB in die axialen Positionen des Cu(II)-Komplexes
- Fig. 3: IV-Kennlinien von HTM-014 sowie HTM-014 dotiert mit Cu(II)TFMS
- Fig. 4: Leitfähigkeiten über der Dotierstoffkonzentration für HTM-014 dotiert mit Cu(II)TFMS
- Fig. 5: Absorptionsspektra von HTM-014 sowie HTM-014 dotiert mit Cu(II)TFMS
- Fig. 6: PL-Spektren von HTM-014 und HTM-014 dotiert mit Cu(II)TFMS
- Fig. 7: Reflexionsspektra von HTM-014 dotiert mit Cu(II)TFMS
- Fig. 8: IV-Kennlinien von HTM-014 sowie HTM-014 dotiert mit Ag(I)TFMS
- Fig. 9: Leitfähigkeiten über der Dotierstoffkonzentration für HTM-014 dotiert mit Ag(I)TFMS
- Fig. 10: Absorptionsspektra von HTM-014 sowie HTM-014 dotiert mit Ag(I)TFMS
- Fig. 11: PL-Spektren von HTM-014 und HTM-014 dotiert mit Ag(I)TFMS
- Fig. 12: Reflexionsspektra von HTM-014 dotiert mit Ag(I)TFMS.

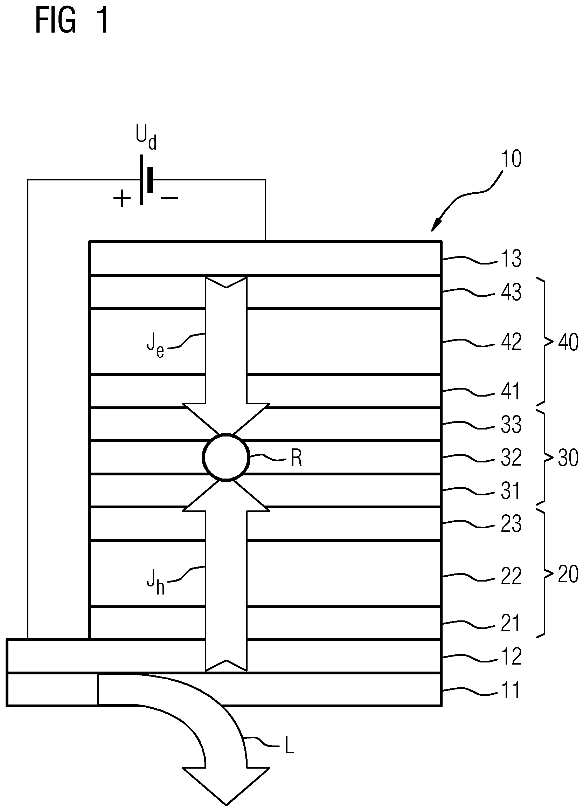

Die Figur 1 zeigt schematisch den Aufbau eines organischen Halbleiterbauelements 10. Dieser Aufbau wird insbesondere für organische Leuchtdioden verwendet. Dabei werden auf ein Glassubstrat 11 eine untere Elektrode 12 und eine obere Elektrode 13 und dazwischen eine Vielzahl organischer Halbleiterschichten abgeschieden. In der Figur 1 ist ein Querschnitt durch die horizontal angeordneten Schichten gezeigt. An die untere 12 und obere 13 Elektrode kann die Bauteilspannung U_{d} angelegt werden. In dem gezeigten Fall ist die obere Elektrode 13 die Kathode der Leuchtdiode und die untere Elektrode 12 ist die Anode der Leuchtdiode. Die Lichtauskopplung L geschieht durch das Glassubstrat 11. Dafür ist die Anode transparent, insbesondere aus Indiumzinnoxid (ITO). An die Anode schließen zunächst die Lochleitschichten 20 an. Dabei können diese für unterschiedliche Schwerpunktsfunktionen ausgestaltet sein. Z.B. stellt die erste Schicht 21 auf der Anode eine Lochinjektionsschicht dar. Die daran anschließende Lochleiterschicht 22 eine Lochtransportschicht und die daran weiter anschließende dritte Lochleiterschicht 23 fungiert als elektronblockende Schicht, um die Elektronen, die von der Kathoden-Seite her kommen, daran zu hindern in den Lochleitbereich einzudringen.

Von der Gegenseite, der Kathodenseite her, schließt sich der Elektronentransportbereich an. Dieser kann ebenso mehrere Elektronleitschichten 40 umfassen. Beispielsweise schließt sich an die Kathode eine erste Elektronenleitschicht 43 an, welche als Elektroneninjektionsschicht wirkt. Daran anschließend ist eine zweite Elektronentransportschicht 42 gezeigt und eine dritte Elektronentransportschicht 41 kann wiederum als lochblockende Schicht eingesetzt sein.

Zwischen dem Elektronentransportbereich und dem Lochtransportbereich befindet sich der Emissionsbereich. Dieser kann wiederum aus mehreren Schichten bestehen. Beispielsweise weist der Emissionsbereich drei Emissionsschichten 30 unterschiedlicher Farbe auf: Eine rote Emissionsschicht 31 schließt an den Lochtransportbereich an, darauf folgt eine grüne Emissionsschicht 32 und eine blaue Emissionsschicht 33 schließt an den Elektrontransportbereich an.

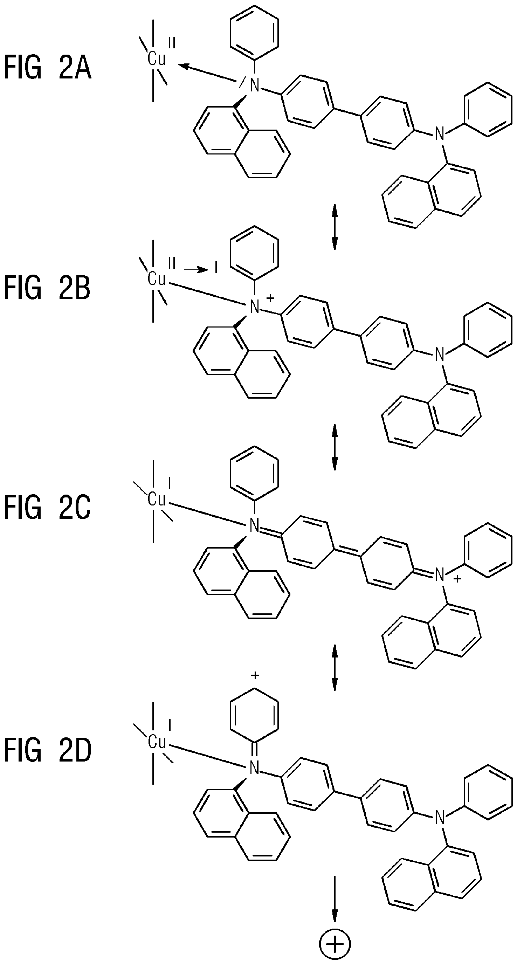

Für die Stapelung solcher OLED kann die erfindungsgemäße Schicht auch in einer Charge-Generation-Layer verbaut sein. Formal kann die Dotierung durch Koordination von ein bis zwei Lochleitermolekülen, wie z.B. NPB, in die axialen Positionen des Cu(II)-Komplexes vorgenommen werden, wie schematisch in Figur 2 gezeigt.

Die Figur 2 zeigt schematisch die verschiedenen Darstellungen der mesomeren Grenzstrukturen des Komplexes: Im Zustand A ist der Dotierstoff, in diesem Beispiel ein Cu(II)-Komplex, nahe an ein Molekül der Lochleitmatrix, in diesem Fall ein NPB-Molekül gebracht. Im Zustand B erfolgt rein formal ein Ladungsübertrag in Form eines Elektrons vom NPB-Molekül auf den Cu(II)-Komplex, d.h. ein Formal-/Partialladungsübertrag einer positiven Ladung auf das NPB-Molekül. Das Kupferatom ist dann nur noch einwertig. Im Zustand C ist gezeigt, dass sich die positive Ladung, auch als Loch bezeichnet, über das NPB-Molekül bewegen kann und im Zustand D auch an ein zweites benachbartes NPB-Molekül übertragen werden kann, was letztendlich dem Hoppingtransport in organischen Halbleitern entspricht.

Diese Koordination kann so stark sein, dass sogar Materialien, die im nicht-koordinierten Zustand bevorzugt elektronenleitend sind, umgepolt werden und zum Lochleiter werden.

In einem Beispiel kann kommerziell verfügbares Kupfer(II) trifluormethansulfonat (Cu(II)TFMS) mittels Zonensublimation bei einem Basisdruck von 2·10⁻⁴ Pa (2·10⁻⁶ mbar) aufgereinigt werden. Hierzu kann das Material insbesondere zweimal sublimiert werden, wodurch vorhandene Rückstände und Verunreinigungen entfernt werden. Dazu können Sublimationsschritte bei unterschiedlicher Temperatur vorgenommen werden.

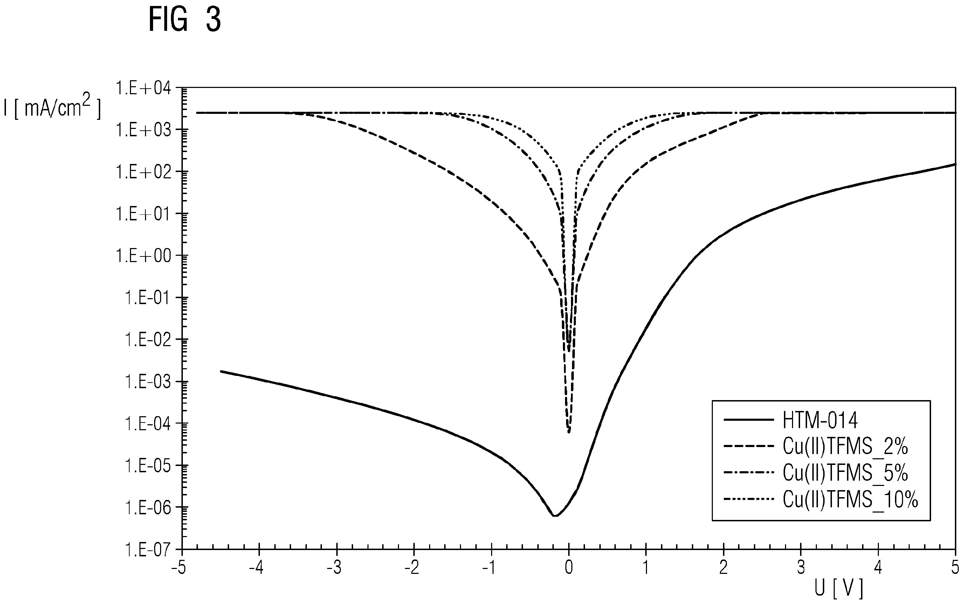

Für die in den Diagrammen der Figuren 3 bis 7 gezeigten Proben erfolgte die erste Sublimation des Cu(II)TFMS bei 350°C - 370 °C und erbrachte eine Ausbeute von 79%. Die zweite Sublimation wurde bei 330°C - 345 °C durchgeführt und ergab eine Ausbeute von 89%. Die Gesamtausbeute dieser Aufreinigung betrug damit gut 70%.

Mit diesem Material wurden auf einer ITO-Elektrode (indiumdotiertes Zinnoxid) durch thermisches Verdampfen eine 200 nm dicke dotierte Lochleiterschicht mit dem Lochleiter-Matrixmaterial HTM-014 abgeschieden. Der Lochleiter wird im Folgenden mit HTM-014 bezeichnet. Dieser kann beispielsweise für Bis-N,N,N',N'-(naphthyl-phenyl)benzidin stehen. Als Gegenelektrode wurde eine 150 nm dicke Aluminiumschicht abgeschieden.

Figur 3 zeigt ein Stromspannungsdiagramm dieses organischen Halbleiterbauelements aus einer Lochleitschicht mit der Cu(II)TFMS p-Dotierung in unterschiedlichen Konzentrationen von 2%, 5% und 10%. Dabei hat das Bauelement eine Grundfläche von 4 mm². Eine Referenzmessung der Strom-Spannungs-Kennlinie des undotierten Lochleiters, im Diagramm als "HTM-014" bezeichnet, verdeutlicht den starken Dotiereffekt des Cu(II)TFMS.

Für alle Konzentrationen kann demnach gezeigt werden, dass die Dotierung einen Effekt auf die Strom-Spannungs-Kennlinie hat. Es zeigt sich für alle Konzentrationen ein deutlicher Anstieg der Stromdichten im Vergleich zum undotierten Referenz-Bauteil aus reinem HTM-014.

Der Dotiereffekt ist insbesondere abhängig von der Dotierstoffkonzentration, was auch durch das Beispiel Cu(II)TFMS in der Figur 3 gezeigt ist. Die Stromdichte steigt mit steigender Konzentration. Dabei stellen die waagerechten Bereiche der Kennlinien keine Strombegrenzung des Bauteils dar, sondern eine Messgrenze des Messaufbaus. Je kleiner die Spannung U_{d}, bei der im Bauteil die maximal messbare Stromdichte gemessen wurde, desto besser ist der Dotiereffekt.

Das symmetrische Verhalten der Strom-Spannungs-Kennlinie für positive und negative Betriebsspannungen U_{d}, zumindest bei Konzentrationen von 5% und 10% zeigt, dass die Lochinjektion unabhängig ist von der Austrittsarbeit der Elektroden und daher für die Aluminium- sowie die ITO-Elektrode gleich gut funktioniert. Die 2%-Probe zeigt kein vollständig symmetrisches Verhalten, da das Matrixmaterial ein Lochtransporter ist. Die Dotierkonzentration von 2% ist noch nicht ausreichend um eine zur ITO-Elektrode vergleichbare Injektion aus der Aluminium-Elektrode zu erreichen.

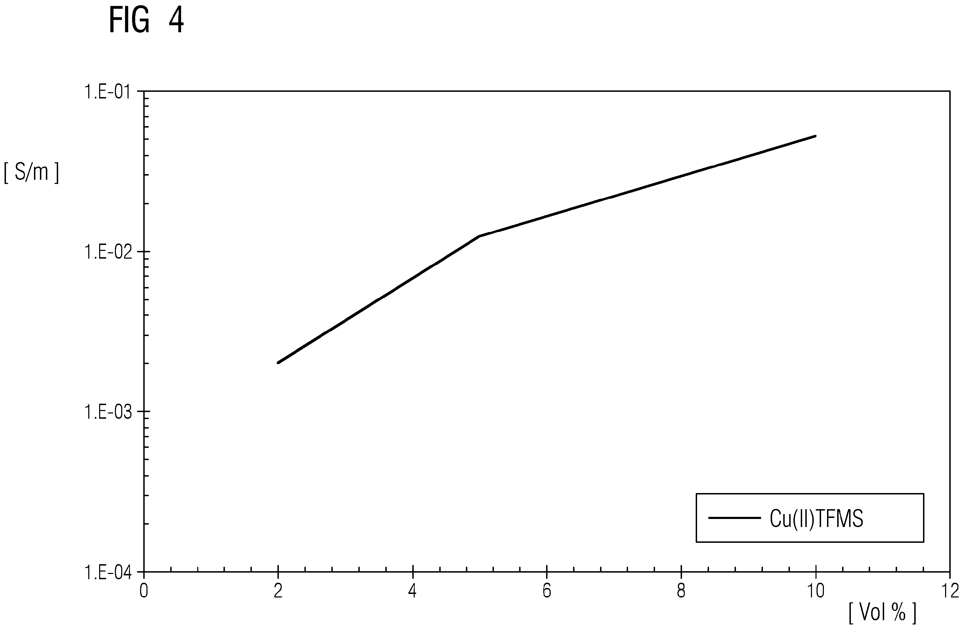

Figur 4 zeigt ein Diagramm, in dem die Leitfähigkeit der dotierten Lochtransportschicht in Siemens/m in Abhängigkeit von der Konzentration des p-Dopanten in der Lochleiterschicht aufgetragen ist. Dazu wurden gleichzeitig mit den Proben für die Messung der Strom-Spannungs-Kennlinien Substrate beschichtet, auf denen die Leitfähigkeit der dotierten Schichten gemessen werden kann. Dazu wurden verschieden dimensionierte Bauteile erzeugt um für die Bestimmung der Leitfähigkeit auszuschließen, dass die gemessenen Effekte von Dicke und Fläche der Bauelemente abhängen. Daraus ergeben sich für die gewählten Dotierkonzentrationen folgende spezifische Werte:

| | | |
|---|---|---|
| 2% | Cu(II)TFMS in HTM-014: | 1,99·10⁻³ S/m |
| 5% | Cu(II)TFMS in HTM-014: | 1,24·10⁻² S/m |
| 10% | Cu(II)TFMS in HTM-014: | 5,25·10⁻² S/m |

Das Diagramm in Figur 4 zeigt die Leitfähigkeiten in Abhängigkeit von der Dotierstoffkonzentration. Der gezeigte Verlauf bestätigt die Figur 3 gezeigten Strom-Spannungs-Kennlinien. Die Leitfähigkeit steigt der Dotierstoffkonzentration genau wie die Stromdichte.

Die Leitfähigkeit ist über noch höhere Dotierstoffkonzentrationen nur bis zu materialspezifischen Grenzwerten steigerbar, da es sich ab einer gewissen Konzentration nicht mehr um einen Dotierung handelt.

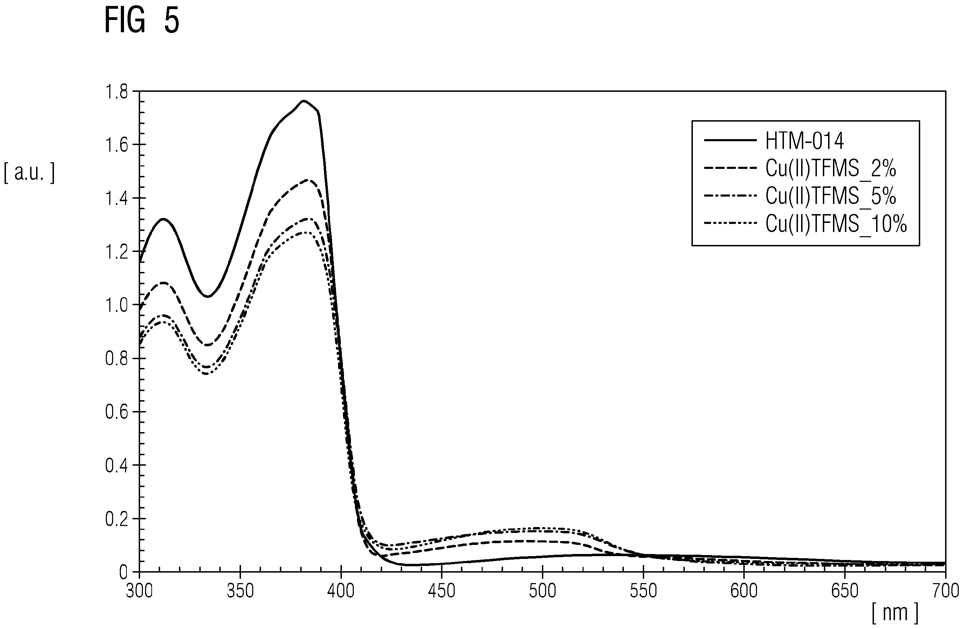

Die Figuren 5, 6 und 7 zeigen die Absorptions-, Emissions- und Reflexionsspektren der mit Cu(II)TFMS dotierten organischen Lochleiterschichten. Dazu wurden diese auf Quarzglassubstraten abgeschieden. Diese Substrate besitzen keine Elektroden-Kontakte und dienen nur zur optischen Messung.

Die Absorptionsspektren in Figur 5 zeigen, dass die absolute Absorption im Absorptionsmaximum bei 384 nm Wellenlänge mit steigender Dotierstoffkonzentration abfällt. Die Absorption des HTM-014 unterhalb von 400 nm wird also durch die Dotierung gesenkt, was an der Bildung eines Charge-Transfer Komplexes liegt.

Gleichzeitig kommt es zu einem Anstieg der Absorption zwischen 410 nm und 550 nm. Auch in diesem Bereich steigt die Absorption mit steigender Dotierstoffkonzentration. Für den sichtbaren Wellenlängenbereich von circa 400nm bis 700 nm steigt also die Absorption im blauen bis grünen Wellenlängenbereich wodurch die Schichten für das menschliche Auge rötlich erscheinen.

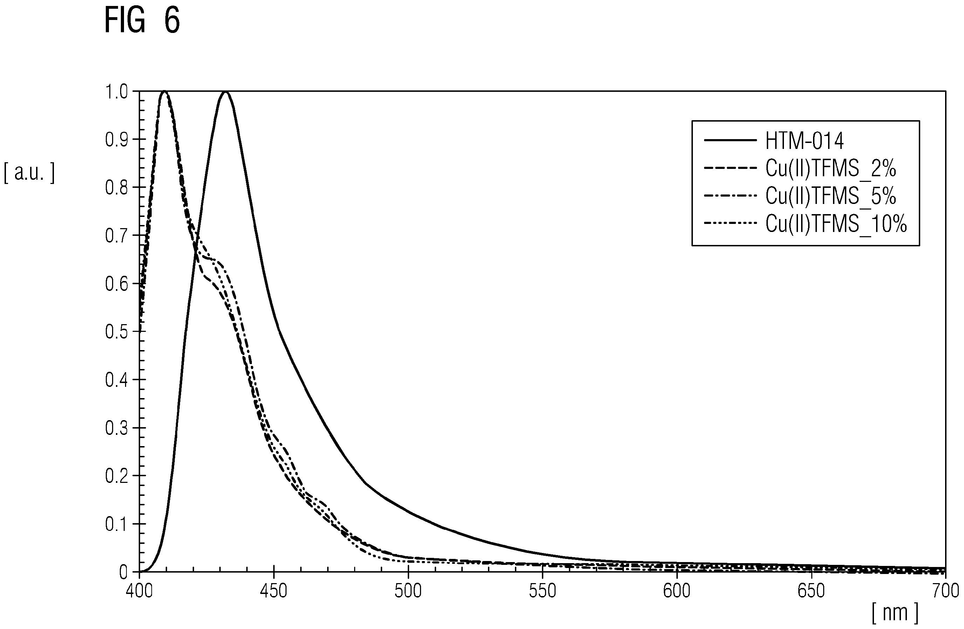

Figur 6 zeigt die Fotolumineszenzspektren der Lochleiterschichten mit der Cu(II)TFMS-Dotierung im Vergleich mit dem Spektrum von undotiertem HTM-014. Die Emission bei einer Wellenlänge von 432 nm wird durch die Dotierung auf 409 nm verschoben. Außerdem bildet sich bei 430 nm eine deutliche Schulter für die dotierten Schichten aus. Verschiebung und Schulterbildung können auf die Bildung eines Charge-Transfer Komplexes zurück geführt werden.

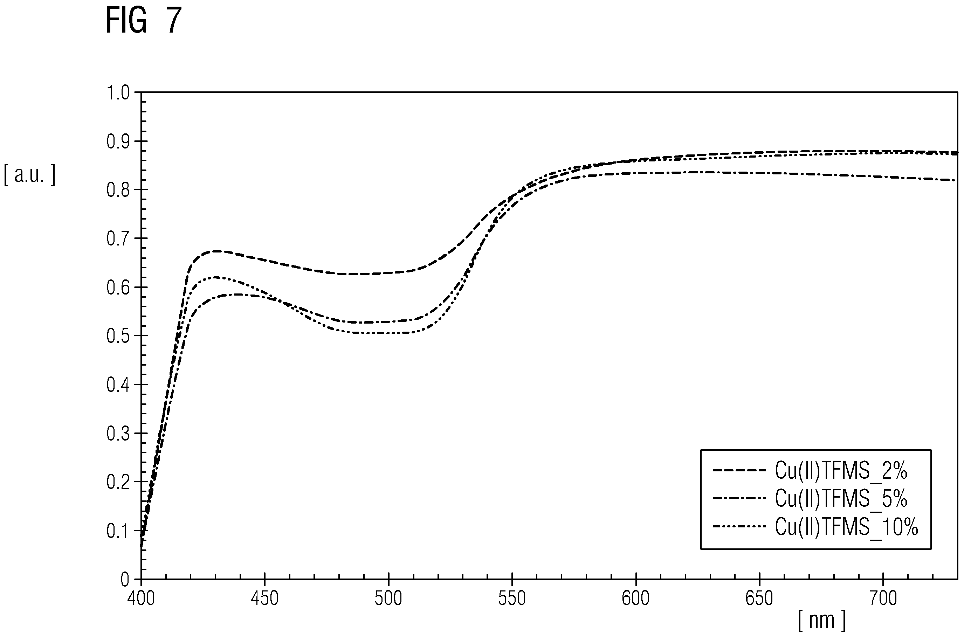

Figur 7 zeigt die Reflexionsspektren der dotierten Lochleiterschichten: Mit steigender Dotierstoffkonzentration fällt die Reflexion im blau-grünen Wellenlängenbereich und bleibt im roten Bereich erhalten. Daher besitzen die erzeugten Schichten einen für das menschliche Auge roten Stich. Auch optisch ist die Abhängigkeit von der Dotierstoffkonzentration zu sehen: Der Farbton der beschichteten Substrate wird für das menschliche Auge mit steigender Konzentration immer dunkler und roter.

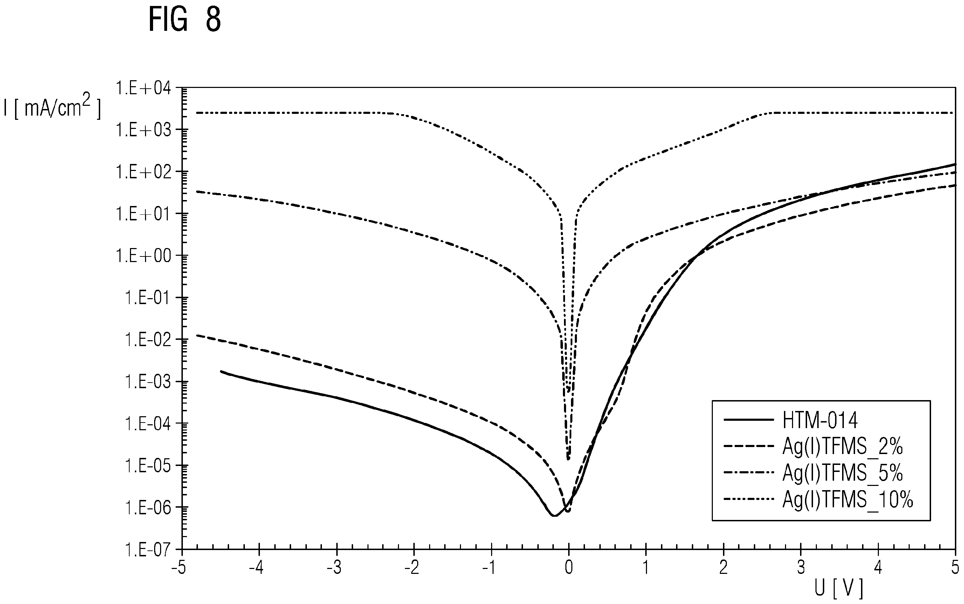

In einem weiteren Beispiel wurde kommerziell verfügbares Silber(I) trifluormethansulfonat (Ag(I)TFMS) verwendet. Für die in den Diagrammen der Figuren 8 bis 12 gezeigten Proben erfolgte auch eine Aufreinigung des Materials: Die Zonensublimation bei einem Basisdruck von 2·10⁻⁴ Pa (2·10⁻⁶ mbar) erfolgte bei 370°C - 380°C und erbrachte eine Ausbeute von 47%. Analog Beispiel Cu(II)TFMS wurde das aufgereinigte Ag(I)TFMS zur Dotierung in die Lochleiter-Matrix HTM-014 eingebracht. Substrate, Elektroden, Schichtdicken und Bauteilgröße sind hierbei identisch zu den Cu(II)TFMS-Proben.

Figur 8 zeigt ein Stromspannungsdiagramm eines organischen Halbleiterbauelements mit einer Lochleitschicht und einer p-Dotierung mit Ag(I)TFMS in unterschiedlichen Konzentrationen. Durch die Variation der Konzentration kann gezeigt werden, dass die Dotierung einen Effekt auf die Strom-Spannungs-Kennlinie hat: Bei 5% Dotier-Konzentration ist eine Erhöhung der Stromdichte für negative sowie für kleine positive Spannungen (<2V) zu sehen. Die Kennlinie bei 5% und 10% Konzentration sind annähernd symmetrisch und zeigen deutlich die erfolgreiche Dotierung und die verbesserte Stromleitfähigkeit. Das symmetrische Verhalten zeigt wiederum, dass die Lochinjektion unabhängig ist von der Austrittsarbeit der Elektroden. Bei 10% Dotier-Konzentration erreicht die Kennlinie wieder die Strombegrenzung des Messgerätes, wie bereits beschrieben.

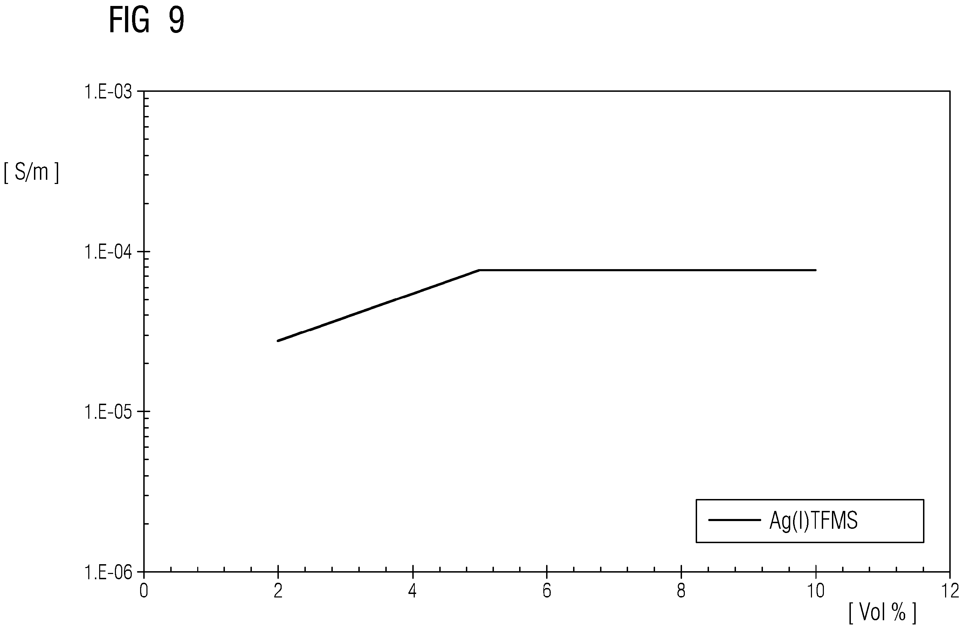

Figur 9 zeigt ein Diagramm, in dem die Leitfähigkeit der Lochtransportschicht in Siemens/m in Abhängigkeit von der Konzentration des p-Dopanten in der Lochleiterschicht aufgetragen ist. Die Proben wurden analog zu den Cu(II)TFMS-Proben hergestellt. Die Bauelemente mit den Ag(I)TFMS-dotierten Lochleitschichten weisen folgende spezifische Leitfähigkeiten in Abhängigkeit von der Dotierkonzentration auf:

| | | |
|---|---|---|
| 2% | Ag(I)TFMS in HTM-014: | 2,76·10^{~5} S/m |
| 5% | Ag(I)TFMS in HTM-014: | 7,66·10⁻⁵ S/m |
| 10% | Ag(I)TFMS in HTM-014: | 7,86·10⁻⁵ S/m |

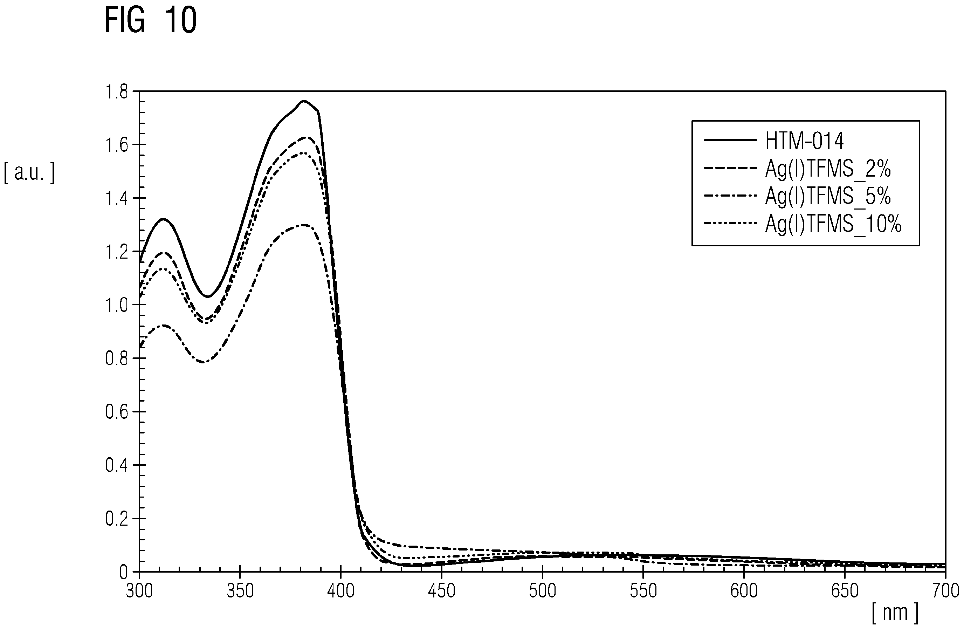

Die Figuren 10, 11 und 12 zeigen die Absorptions-, Emissions- und Reflexionsspektren der mit Ag(I)TFMS dotierten organischen Lochleiterschichten. Dazu wurden diese wiederum auf Quarzglassubstraten abgeschieden.

Die Absorptionsspektren in Figur 10 zeigen, dass die absolute Absorption im Absorptionsmaximum bei 384 nm Wellenlänge mit steigender Dotierstoffkonzentration abfällt. Gleichzeitig kommt es zu einem Anstieg der Absorption zwischen 410 nm und 550 nm mit steigender Dotierstoffkonzentration. Für den sichtbaren Wellenlängenbereich von circa 400 nm bis 700 m steigt die Absorption zwar leicht an, aber im Gegensatz zu den Cu(II)TFMS-Proben sind die Schichten für das menschliche Auge farblich weiterhin neutral.

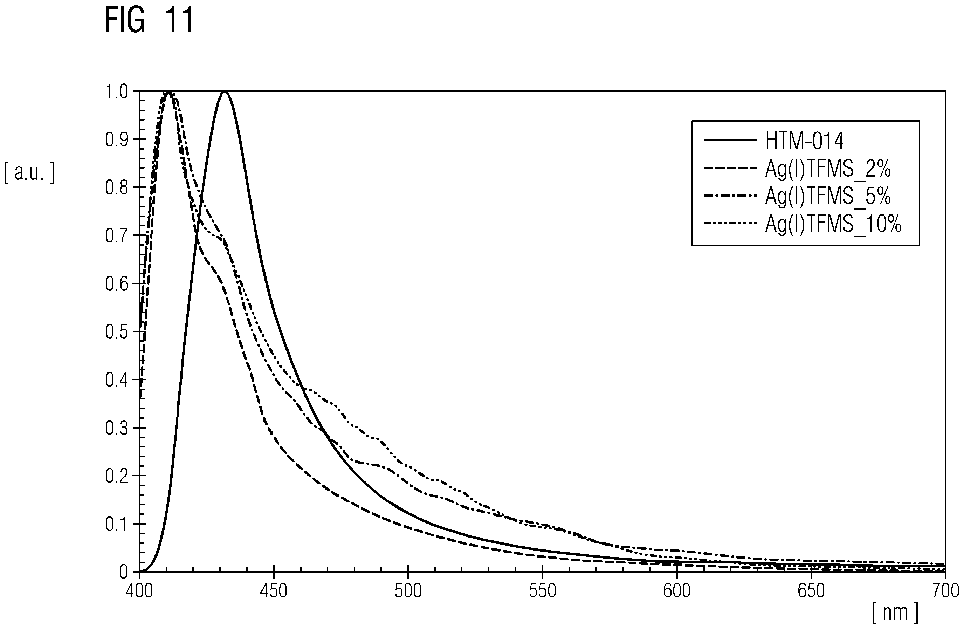

Figur 11 zeigt die Fotolumineszenzspektren der Lochleiterschichten mit Ag(I)-TFMS-Dotierung. Deren Vergleich dem Spektrum von undotiertem HTM-014 zeigt, dass sich die vom HTM-014 übliche Emission bei einer Wellenlänge von 432 nm durch die Dotierung auf 410 nm verschiebt. Außerdem bildet sich bei 430 nm eine deutliche Schulter für die dotierten Schichten aus. Diese Verschiebung und Schulterbildung ist wiederum auf die Bildung eines Charge-Transfer Komplexes zurück zu führen.

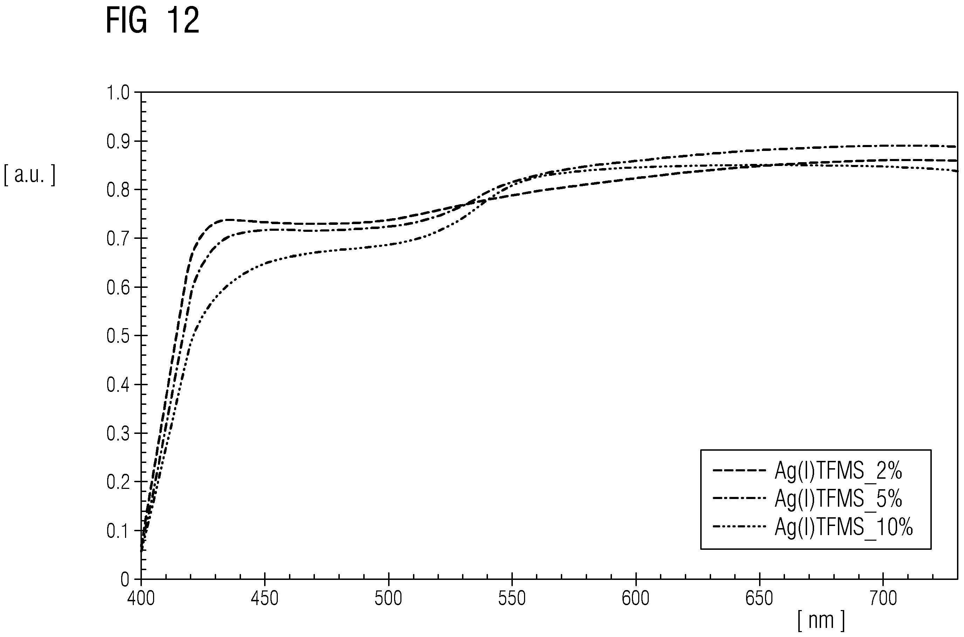

Figur 12 zeigt die Reflexionsspektren der dotierten Lochleiterschichten. Mit steigender Dotierstoffkonzentration fällt die Reflexion im blau-grünen Wellenlängenbereich sehr leicht ab und bleibt im roten Wellenlängenbereich erhalten, abhängig von der Dotierstoffkonzentration. Für das menschliche Auge weisen die Schichten einen neutralen Farbton auf.

## Patentansprüche

1. Halbleiterbauelement (10) mit wenigstens einer organischen Lochleiterschicht (20), die eine p-Dotierung mit einem Supersäurensalz aufweist, **dadurch gekennzeichnet, dass** das Supersäurensalz Silber(I)trifluormethansulfonat (Ag(I)TFMS) und/oder Kupfer(II)trifluormethansulfonat (Cu(II)TFMS) aufweist.

2. Halbleiterbauelement (10) nach Anspruch 1, wobei die Lochleiterschicht (20), die eine p-Dotierung mit einem Supersäurensalz aufweist, eine spezifische Leitfähigkeit von mindestens 2,5·10⁻⁵ S/m bei einer Dotierkonzentration von höchstens 20 Vol.-% aufweist.

3. Halbleiterbauelement (10) nach einem der vorstehenden Ansprüche, wobei das Supersäurensalz Silber(I)trifluormethansulfonat (Ag(I)TFMS) aufweist und das Absorptionsvermögen der Lochleiterschicht (20) im Wellenlängenbereich zwischen 400 nm und 700 nm durch die p-Dotierung mit dem Supersäuresalz im Wesentlichen nicht erhöht wird, so dass der Farbeindruck für das menschliche Auge unverändert bleibt.

4. Herstellungsverfahren für ein Halbleiterbauelement (10) mit einem Schritt zur Abscheidung einer organischen Lochleiterschicht (20), die eine p-Dotierung mit einem Supersäurensalz aufweist, **dadurch gekennzeichnet, dass** das Supersäurensalz Silber(I)trifluormethansulfonat (Ag(I)TFMS) und/oder Kupfer(II)trifluormethansulfonat (Cu(II)TFMS) aufweist.

5. Herstellungsverfahren nach Anspruch 4, wobei für die Abscheidung der Lochleiterschicht (20) ein Matrixmaterial zusammen mit dem Supersäurensalz in einem gemeinsamen Schritt abgeschieden wird.

6. Herstellungsverfahren nach einem der Ansprüche 4 oder 5, wobei Matrixmaterial und das Supersäurensalz aus der Gasphase, insbesondere durch thermisches Verdampfen abgeschieden werden.

7. Herstellungsverfahren nach Anspruch 5 und Anspruch 6, wobei die Dotierkonzentration der Lochleiterschicht (20) über die Verdampfungsraten des Supersäurensalzes und des Matrixmaterials in einer Ko-Verdampfung eingestellt wird.

8. Herstellungsverfahren nach einem der Ansprüche 4 oder 5, wobei Matrixmaterial und das Supersäurensalz aus Lösung abgeschieden werden.

9. Herstellungsverfahren nach Anspruch 5 und Anspruch 8, wobei die Dotierkonzentration der Lochleiterschicht (20) über den Massenanteil des Supersäurensalzes und des Matrixmaterials in der Lösung vor der Abscheidung eingestellt wird.

10. Herstellungsverfahren für ein Halbleiterbauelement (10) mit einem Schritt zur Abscheidung einer organischen Lochleiterschicht (20), die eine p-Dotierung mit einem Supersäurensalz aufweist, wobei das Supersäurensalz ein Salz einer Supersäure aufweist, und wobei die Supersäure eine Säure mit einem Säurekonstantewert pKs kleiner als der von Schwefelsäure ist, **dadurch gekennzeichnet, dass** für die Abscheidung der Lochleiterschicht (20) ein Matrixmaterial zusammen mit dem Supersäurensalz in einem gemeinsamen Schritt aus der Gasphase abgeschieden wird, wobei die Dotierkonzentration der Lochleiterschicht (20) über die Verdampfungsraten des Supersäurensalzes und des Matrixmaterials in einer Ko-Verdampfung eingestellt wird.

## Claims

1. Semiconductor component (10) with at least one organic hole conductor layer (20) having p-doping with a superacid salt, **characterized in that** the superacid salt comprises silver(I) trifluoromethanesulfonate (Ag(I)TFMS) and/or copper(II) trifluoromethanesulfonate (Cu(II)TFMS).

2. Semiconductor component (10) according to Claim 1, wherein the hole conductor layer (20) having p-doping with a superacid salt has a specific conductivity of at least 2.5·10⁻⁵ S/m at a dopant concentration of not more than 20% by volume.

3. Semiconductor component (10) according to either of the preceding claims, wherein the superacid salt comprises silver(I) trifluoromethanesulfonate (Ag(I)TFMS) and the absorption capacity of the hole conductor layer (20) in the wavelength range between 400 nm and 700 nm is essentially not increased by the p-doping with the superacid salt, such that the color impression to the human eye remains unchanged.

4. Production process for a semiconductor component (10) comprising a step for deposition of an organic hole conductor layer (20) having p-doping with a superacid salt, **characterized in that** the superacid salt comprises silver(I) trifluoromethanesulfonate (Ag(I)TFMS) and/or copper(II) trifluoromethanesulfonate (Cu(II)TFMS).

5. Production process according to Claim 4, wherein a matrix material is deposited together with the superacid salt in a combined step for the deposition of the hole conductor layer (20).

6. Production process according to either of Claims 4 and 5, wherein matrix material and the superacid salt are deposited from the gas phase, especially by thermal evaporation.

7. Production process according to Claim 5 and Claim 6, wherein the dopant concentration of the hole conductor layer (20) is adjusted via the evaporation rates of the superacid salt and of the matrix material in a coevaporation.

8. Production process according to either of Claims 4 and 5, wherein matrix material and the superacid salt are deposited from solution.

9. Production process according to Claim 5 and Claim 8, wherein the dopant concentration of the hole conductor layer (20) is adjusted via the proportion by mass of the superacid salt and of the matrix material in the solution prior to deposition.

10. Production process for a semiconductor component (10) comprising a step for deposition of an organic hole conductor layer (20) having p-doping with a superacid salt, wherein the superacid salt comprises a salt of a superacid, and wherein the superacid is an acid having an acidic constant value pKa lower than that of sulfuric acid, **characterized in that**, for the deposition of the hole conductor layer (20), a matrix material is deposited from the gas phase in a combined step together with the superacid salt, wherein the dopant concentration of the hole conductor layer (20) is adjusted via the evaporation rates of the superacid salt and of the matrix material in a coevaporation.

## Revendications

1. Composant semi-conducteur (10) comprenant au moins une couche conductrice perforée organique (20), qui comprend un dopage p avec un sel de superacide, **caractérisé en ce que** le sel de superacide comprend du trifluorométhane-sulfonate d'argent (I) (Ag(I)TFMS) et/ou du trifluorométhane-sulfonate de cuivre (II) (Cu(II)TFMS).

2. Composant semi-conducteur (10) selon la revendication 1, dans lequel la couche conductrice perforée (20), qui comprend un dopage p avec un sel de superacide, présente une conductivité spécifique d'au moins 2,5 · 10⁻⁵ S/m à une concentration de dopage d'au plus 20 % en volume.

3. Composant semi-conducteur (10) selon l'une quelconque des revendications précédentes, dans lequel le sel de superacide comprend du trifluorométhane-sulfonate d'argent (I) (Ag(I)TFMS) et la capacité d'absorption de la couche conductrice perforée (20) dans la plage de longueur d'onde comprise entre 400 nm et 700 nm n'est pas sensiblement augmentée par le dopage p avec le sel de superacide, de telle sorte que l'impression de couleur pour l'œil humain reste inchangée.

4. Procédé de fabrication pour un composant semi-conducteur (10) comprenant une étape de dépôt d'une couche conductrice perforée organique (20), qui comprend un dopage p avec un sel de superacide, **caractérisé en ce que** le sel de superacide comprend du trifluorométhane-sulfonate d'argent (I) (Ag(I)TFMS) et/ou du trifluorométhane-sulfonate de cuivre (II) (Cu(II)TFMS).

5. Procédé de fabrication selon la revendication 4, dans lequel, pour le dépôt de la couche conductrice perforée (20), un matériau de matrice est déposé conjointement avec le sel de superacide dans une étape commune.

6. Procédé de fabrication selon l'une quelconque des revendications 4 ou 5, dans lequel du matériau de matrice et le sel superacide sont déposés à partir de la phase gazeuse, notamment par évaporation thermique.

7. Procédé de fabrication selon la revendication 5 et la revendication 6, dans lequel la concentration de dopage de la couche conductrice perforée (20) est ajustée par l'intermédiaire des taux d'évaporation du sel de superacide et du matériau de matrice dans une co-évaporation.

8. Procédé de fabrication selon l'une quelconque des revendications 4 ou 5, dans lequel du matériau de matrice et le sel superacide sont déposés à partir d'une solution.

9. Procédé de fabrication selon la revendication 5 et la revendication 8, dans lequel la concentration de dopage de la couche conductrice perforée (20) est ajustée par l'intermédiaire de la proportion massique du sel de superacide et du matériau de matrice dans la solution avant le dépôt.

10. Procédé de fabrication pour un composant semi-conducteur (10) comprenant une étape de dépôt d'une couche conductrice perforée organique (20), qui comprend un dopage p avec un sel de superacide, le sel de superacide comprenant un sel d'un superacide et le superacide étant un acide ayant une valeur de constante d'acidité pKₛ inférieure à celle de l'acide sulfurique, **caractérisé en ce que,** pour le dépôt de la couche conductrice perforée (20), un matériau de matrice est déposé conjointement avec le sel de superacide dans une étape commune à partir de la phase gazeuse, la concentration de dopage de la couche conductrice perforée (20) étant ajustée par l'intermédiaire des taux d'évaporation du sel de superacide et du matériau de matrice dans une co-évaporation.
